# EUROPÄISCHE PATENTSCHRIFT

(11) **EP 3 384 666 B1**
(45) Veröffentlichungstag und Bekanntmachung des Hinweises auf die Patenterteilung: **07.07.2021**
(21) Anmeldenummer: 16701450.5
(22) Anmeldetag: 22.01.2016
(51) Int. Cl.: H04N 5/225, H01R 13/52, H01R 24/50

(54) **KAMERAMODUL**
CAMERA MODULE
MODULE CAMÉRA

(43) Veröffentlichungstag der Anmeldung: 10.10.2018
(73) Patentinhaber: Rosenberger Hochfrequenztechnik GmbH & Co. KG, 83413 Fridolfing (DE)
(72) Erfinder: BIPPUS, Rainer, 83317 Teisendorf (DE); SCHMID, Johannes, 84503 Altötting (DE)
(86) Internationale Anmeldenummer: PCT/EP2016/051292
(87) Internationale Veröffentlichungsnummer: WO 2017/125163

(56) Entgegenhaltungen:
- EP-A2- 2 541 110
- JP-A- 2010 078 772
- JP-A- 2015 222 649
- US-A1- 2013 242 099
- US-A1- 2015 029 337
- US-A1- 2015 365 569

## Beschreibung

### GEBIET DER ERFINDUNG

Die vorliegende Erfindung betrifft ein Kameramodul zur Verwendung im Automobilbereich.

### TECHNISCHER HINTERGRUND

Kameras im Automobilbereich sind seit längerem ein gängiges Mittel, um die Sicherheit und den Komfort für einen Kraftfahrzeugführer erhöhen. Derartige Kameras müssen im Alltag erheblichen Belastungen durch Schmutz, Wasser und mechanische Lasten standhalten.

Um die geforderte Robustheit eines derartigen Kameramoduls bereitzustellen, werden Kameramodulgehäuse häufig aus Metall, insbesondere aus Aluminium, gefertigt.

Gehäuse aus Metall, insbesondere aus Aluminium, haben sich jedoch aufgrund hoher Materialkosten sowie erheblicher Verschleißerscheinungen bei metallverarbeitenden Werkzeugen als nachteilig herausgestellt.

Vor diesem Hintergrund zeigt die WO 2013/085796 A1 eine radiale Dichtung für ein Kameragehäuse aus Kunststoff.

Nachteilig hieran ist jedoch, dass ein Gehäusedeckel aufwendig an vier Befestigungspunkte mit dem Gehäuse verschraubt werden muss. Zudem muss der Gehäusedeckel vorgegebenen Abmessungen präzise entsprechen. Insbesondere kommt es bereits bei geringfügigen Unregelmäßigkeiten des Gehäusedeckels zu Schwierigkeiten bei der Kontaktierung zwischen einer Leiterplatte und einer Schnittstelle sowie zu Undichtigkeiten im Gehäuse.

Dies ist ein Zustand, den es zu verbessern gilt.

Die JP 2010 078772 A zeigt ein Kameramodul, insbesondere zur Verwendung im Automobilbereich, mit einer Leiterplattenanordnung, wobei die Leiterplattenanordnung zumindest eine Leiterplatte und einen Bildsensor aufweist; einer Schnittstelle zur Datenübertragung, welche die Leiterplatte kontaktiert; einem Kameramodulgehäuse, welches eine umlaufende Wandung aufweist; einem schnittstellenseitigem Abdeckelement; einem Ausgleichselement, welches zwischen der umlaufenden Wandung und dem Abdeckelement angeordnet ist; wobei das Ausgleichselement eingerichtet ist, das Kameramodulgehäuse abzudichten sowie einen Spielraum zwischen dem Abdeckelement und der umlaufenden Wandung auszugleichen.

### ZUSAMMENFASSUNG DER ERFINDUNG

Vor diesem Hintergrund liegt der vorliegenden Erfindung die Aufgabe zugrunde, ein verbessertes Kameramodul anzugeben.

Erfindungsgemäß wird diese Aufgabe durch ein Kameramodul mit den Merkmalen des Patentanspruchs 1 gelöst.

Die der vorliegenden Erfindung zugrunde liegende Idee besteht darin, einen Ausgleich von Spielraum zwischen dem Abdeckelement und dem Kameramodulgehäuse zu schaffen. Maßgeblich hierfür ist unter anderem die Minimierung von axial wirkenden Kräften, da Axialkräfte nach längerem Gebrauch Undichtigkeiten im Kameramodulgehäuse hervorrufen können. Zudem führt eine Axialverpressung der Bauteile in einem Kameramodulgehäuse häufig zu Beschädigungen während der Montage. Dementsprechend können durch das erfindungsgemäße Ausgleichselement die zur Abdichtung des Kameramoduls notwendigen axialen Kräfte verringert werden und eine ausreichende Dichtigkeit kann durch eine radial wirkende Dichtung erreicht werden.

Ein erfindungsgemäßes Ausgleichselement ist als dreidimensionale Lippendichtung ausgebildet. Lippendichtungen verfügen, insbesondere gegenüber zweidimensionalen O-Ringen, über ein verbessertes Spaltdichtvermögen. Zudem sind geringe Wassermengen beim Abdichten hilfreich, indem Wasser in den Lippenspalt eindringt und die Lippendichtung an die Gehäusewandung presst. Des Weiteren verfügen Lippendichtungen über eine verlängerte Lebensdauer, beispielsweise gegenüber O-Ringen.

Erfindungsgemäß ist ein im Wesentlichen H- oder hantelförmiger Querschnitt des Ausgleichselements vorgesehen. Dementsprechend weist das Ausgleichselement zwei parallele Schenkel sowie einen mittleren Steg zwischen den Schenkeln auf. Diese Querschnittsform des Ausgleichselements gewährleistet eine maximale Anpassungsmöglichkeit des Ausgleichselements an die innere Gehäusekontur.

Vorteilhafte Ausgestaltungen und Weiterbildungen ergeben sich aus den weiteren Unteransprüchen sowie aus der Beschreibung unter Bezugnahme auf die Figuren der Zeichnung.

Als besonders vorteilhaft erweist sich ein erfindungsgemäßes Ausgleichselement mit einer dreidimensionalen Struktur. Dies gewährleistet die flexible Verformung und Anpassung des Ausgleichselements an einen Spielraum zwischen dem Abdeckelement und der umlaufenden Gehäusewandung.

Praktische Versuchsreihen haben ergeben, dass die radiale Verformbarkeit des Ausgleichselements in einem montierten Zustand vorteilhafter Weise zwischen 0,001 % und 2 %, insbesondere zwischen 0,005 % und 1%, weiter insbesondere zwischen 0,1 % und 0,5 % des Durchmessers des Ausgleichselements beträgt. Dementsprechend schmiegt sich das Abdeckelement an die Gehäusewandung an und gewährleistet so eine maximale Dichtigkeit bei maximalen Fertigungstoleranzen.

Das erfindungsgemäße Ausgleichselement weist vorteilhafterweise einen geringeren Härtegrad als ein O-Ring von vergleichbarem Durchmesser auf. Geeignete Härtegrade für das erfindungsgemäße Ausgleichselement betragen insbesondere zwischen 30 Shore und 50 Shore. Ein Härtegrad im angegebenen Bereich stellt eine ausreichende Flexibilität des Ausgleichselements sicher, um den Spielraum zwischen dem Abdeckelement und dem Kameramodulgehäuse auszugleichen.

Insbesondere ermöglicht das erfindungsgemäße Kameramodul eine Befestigung des Abdeckelements an dem Gehäuse an lediglich zwei Befestigungspunkten. Dies verringert Arbeitskosten und Arbeitsschritte gegenüber konventionellen Kameramodulen mit vier Befestigungspunkten.

Gemäß einer bevorzugten Ausführungsform ist das Kameramodulgehäuse und/oder das Abdeckelement aus Kunststoff, insbesondere aus spritzgegossenem Kunststoff gefertigt. Kunststoff ist ein besonders kostengünstiger Werkstoff, der zudem die verwendeten verarbeitenden Werkzeuge schont.

Gemäß einer bevorzugten Ausführungsform sind das Kameramodulgehäuse aus Metall, insbesondere Aluminium, und das Abdeckelement aus Kunststoff gefertigt. Neben den vorstehend erwähnten Vorteilen ist Kunststoff selbst mit einer sehr filigranen Struktur leicht zu formen. Abhängig von der Länge der Betriebszeiten der Kamera ist ein Kameramodulgehäuse aus Metall mit einer besseren Wärmeleitfähigkeit als Kunststoff vorteilhaft, um eine Überhitzung des Kameramoduls zu vermeiden.

Die Abmessungen gattungsgemäßer Kameramodule betragen typischerweise bis zu 50mm x 50mm x 70mm, insbesondere bis zu 30mm x 30mm x 50mm, weiter insbesondere bis zu 20mm x 20mm x 30mm.

Gemäß einer bevorzugten Weiterbildung ist zwischen der Leiterplattenanordnung und dem Kameramodulgehäuse ein EMV-Modul, beispielsweise ein EMV-Käfig, angeordnet. Das EMV-Modul dient der Abschirmung vor elektromagnetischer Strahlung von außen und verhindert die Abstrahlung elektromagnetischer Wellen durch das Kameramodul. Dies gewährleistet die zuverlässige Abschirmung der Kameramodulelektronik, insbesondere in einem Kunststoffgehäuse und verhindert so eine Störung durch elektromagnetische Interferenzen.

Gemäß einer bevorzugten Weiterbildung weist das Kameramodulgehäuse in dem Bereich des Ausgleichselements eine Vertiefung auf. Durch die Vertiefung wird die Gefahr, dass das Gehäuse während der Montage der Leiterplattenanordnung durch eine Leiterplatte beschädigt wird, verringert. Durch etwaige Beschädigungen, insbesondere Kratzer, im Gehäuse, kann eine Abdichtung des Kameramodulgehäuses durch das Ausgleichselement nicht mehr sichergestellt werden.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnung angegebenen Ausführungsbeispiele näher erläutert. Es zeigen dabei:
- Fig. 1: eine perspektivische Ansicht einer Ausführungsform eines erfindungsgemäßen Kameramoduls;
- Fig. 2a: eine Schnittsicht einer Ausführungsform eines erfindungsgemäßen Kameramoduls;
- Fig. 2b: eine Schnittsicht einer Ausführungsform eines erfindungsgemäßen Kameramoduls;
- Fig. 3: eine perspektivische Draufsicht einer Ausführungsform eines erfindungsgemäßen Abdeckelements;
- Fig. 4: eine perspektivische Unteransicht eines Abdeckelements eines erfindungsgemäßen Kameramoduls;
- Fig. 5: eine schematische Draufsicht einer Ausführungsform eines erfindungsgemäßen Kameramoduls;
- Fig. 6: eine schematische Unteransicht einer Ausführungsform eines erfindungsgemäßen Kameramoduls;

Die beiliegenden Figuren der Zeichnung sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

### BESCHREIBUNG VON AUSFÜHRUNGSBEISPIELEN

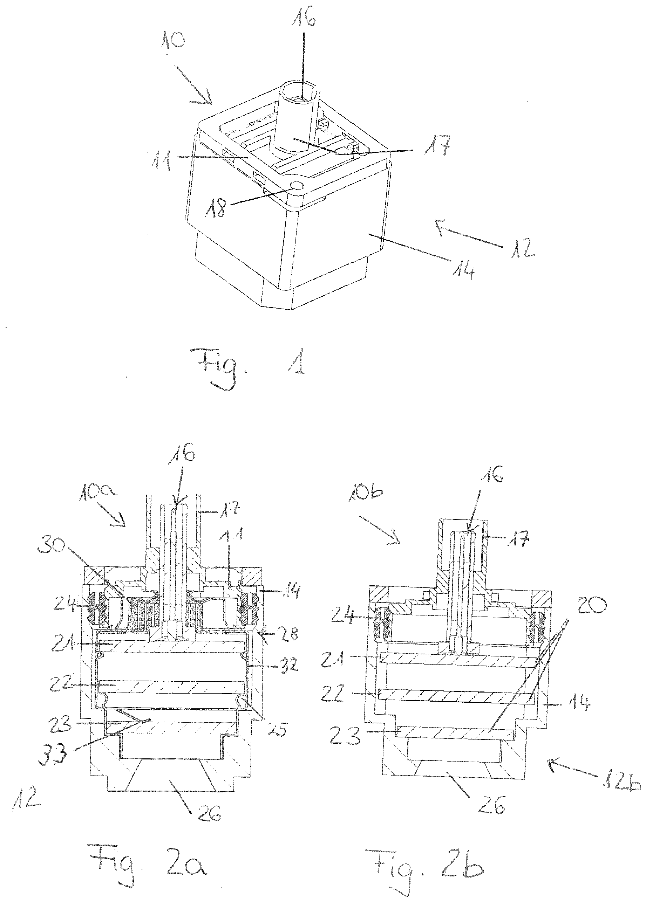

Figur 1 zeigt eine schematische Perspektivansicht einer Ausführungsform eines erfindungsgemäßen Kameramoduls 10. Das Kameramodul 10 weist ein Abdeckelement 11 und ein Kameramodulgehäuse 12 mit einer umlaufenden Wandung 14 auf. Das Abdeckelement 11 enthält eine Schnittstelle 16, welche in einer Schnittstellenummantelung 17 angeordnet ist. Die Schnittstelle kann beispielsweise als Fakra-, HSD-, MTD- oder dergleichen ausgebildet sein.

In Figur 1 ist das Abdeckelement 11 an zwei Befestigungspunkten bzw. Bohrungen 18 mit dem Kameramodulgehäuse 12 verschraubt.

Figur 2a zeigt eine schematische Schnittsicht einer Ausführungsform eines erfindungsgemäßen Kameramoduls 10a. Entsprechend dem Kameramodul 10 aus Figur 1 weist das Kameramodul 10a in Figur 2a ein Abdeckelement 11, ein Kameramodulgehäuse 12 aus Kunststoff sowie eine Schnittstelle 16 auf. Zudem sind in der Figur 2a die Leiterplattenanordnung 20 mit den Leiterplatten 21, 22 und 23, das Ausgleichselement 24, die Linse 26, das EMV-Modul 28, welches als EMV-Korpus ausgebildet ist, sowie ein Kontaktelement 30, welches hier als Federkorb ausgebildet ist, dargestellt.

In Figur 2a ist die Schnittstelle 16 als Fakra-Schnittstelle ausgebildet. Die Fakra-Schnittstelle kontaktiert die Leiterplatte 21, innerhalb des EMV-Korpus 28, und kann mit dieser direkt verbunden oder über einen Steckverbinder verbunden sein. Innerhalb des EMV-Korpus 28 ist eine zweite Leiterplatte 22 zur Signalverarbeitung angeordnet. Beide Leiterplatten 21, 22 liegen auf Stufen 25 auf. Optional können die Stufen 25 auch als Kontaktpunkte für das EMV-Modul 28 verwendet werden. Des Weiteren ist gegenüberliegend zu der Linse 26 eine dritte Leiterplatte 23 angeordnet. Die dritte Leiterplatte 23 weist einen Bildsensor (nicht dargestellt) auf und ist durch den Kontakt 33 mit dem EMV-Korpus kontaktiert.

Das Abdeckelement 11 ist in das Kameramodulgehäuse 12 eingesetzt. Zwischen der umlaufenden Wandung 14 des Kameramodulgehäuses 12 ist das Ausgleichselement 24 positioniert. In der Ausführungsform gemäß Figur 2a ist das Ausgleichselement 24 als H-förmige Dreilippendichtung ausgebildet. Ein Mittelsteg zwischen zwei Schenkeln der Dreilippendichtung gewährleistet die maximale Verformbarkeit der Dreilippendichtung bei gleichzeitiger minimaler Belastung der Dichtung.

Durch das Ausgleichselement 24 wird erreicht, dass das Abdeckelement 11 mit dem Kameramodulgehäuse 12 spritzwasserdicht verbunden ist. Zudem gewährleistet das Ausgleichselement 24 eine ausreichende Toleranz von Spielraum, um eine exakte Positionierung der Schnittstelle 16 auf der Leiterplatte zu gewährleisten. Die exakte Positionierung ist, insbesondere für die Kontaktierung der Schnittstelle 16 mit der Leiterplatte 21, von Bedeutung, da bereits kleinste Verschiebungen des Abdeckelements 11 zu Kontaktierungsproblemen führen.

In Figur 2a ist das EMV-Modul 28 zweiteilig ausgebildet. Das EMV-Modul 28 umfasst eine linsenseitige Wandung, aus leitendem Material und ein abdeckelementseitiges Kontaktelement 30. Die linsenseitige Wandung kann insbesondere auch mehrteilig ausgebildet sein. Das Kontaktelement 30 weist federelastische Kontakte 31 auf, welche die Wandung 32 kontaktieren.

Figur 2b zeigt eine weitere Ausführungsform eines erfindungsgemäßen Kameramoduls 10b. Das Kameramodul 10b weist ein Kameramodulgehäuse 12b auf, welches jedoch im Gegensatz dem Kameramodulgehäuse 12 aus Figur 2a aus Aluminium gefertigt ist. Folglich dient das Kameramodulgehäuse 12b bereits der Abschirmung und ein zusätzlicher EMV-Korpus nicht zwingend erforderlich.

Sowohl in Figur 2a als auch in Figur 2b weist die Wandung 14 des Kameramodulgehäuses 10a, 10b eine Vertiefung 52 auf, um zu verhindern, dass die Wandung 14 des Kameramodulgehäuses während der Montage der Leiterplatten 21, 22 oder 23 verkratzt. Etwaige Beschädigungen an der Wandung 14 können der Dichtigkeit des Kameramodulgehäuses entgegenstehen.

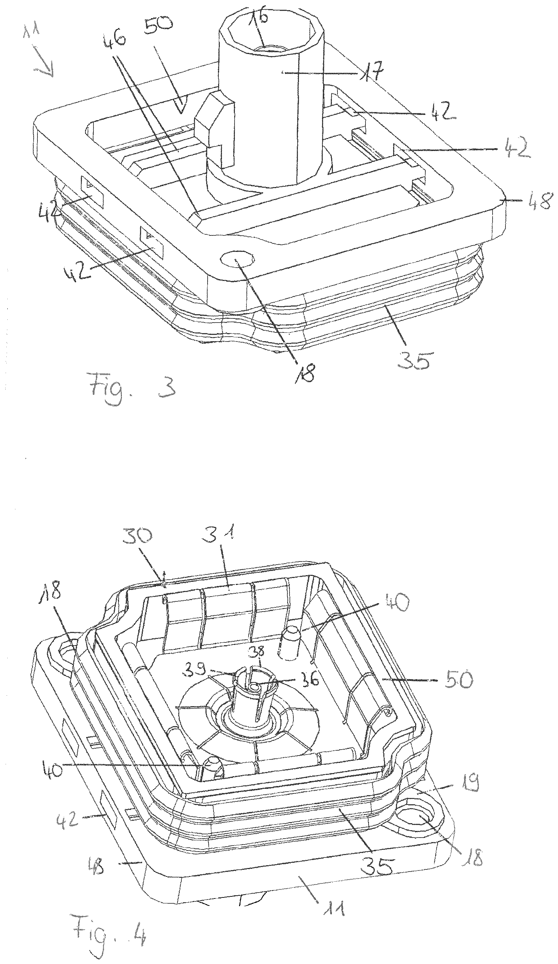

Figur 3 zeigt eine perspektivische Draufsicht eines erfindungsgemäßen Abdeckelements 11 mit einem Funktionselement 50 und einem Fixierrahmen 48. Der Fixierrahmen 48 weist zwei Bohrungen 18 auf, um das Abdeckelement 11 mit einem Kameramodulgehäuse zu verschrauben. Der Fixierrahmen 48 weist an gegenüberliegenden Seiten jeweils zwei Ausnehmungen 42 auf, in welchen das Funktionselement 50 an Stegen 46 eingehängt ist. Das Funktionselement 50 umfasst beispielhaft eine Fakra Schnittstelle 16, ein Ausgleichselement 35 sowie das Kontaktelement 30 zur EMV-Schirmung. Die Fakra-Schnittstelle 16 und das Kontaktelement 30 sind auf dem Funktionselement 50 angeordnet. Durch die spielbehaftete Lagerung der Stege 46 in den Ausnehmungen 42 kann die Schnittstelle 16 im Funktionselement 50 auf die Platine 21 ausgerichtet werden..

In Figur 3 ist das Ausgleichselement 35 als einfache Dreilippendichtung ausgebildet. Das Abdeckelement 11 ist mit dem Ausgleichselement 35 verklebt. Es versteht sich jedoch, dass eine Befestigung des Ausgleichselements 35 an dem Abdeckelement 11 nicht zwingend erforderlich ist. Des Weiteren muss eine Befestigung nicht zwingend durch Kleben erfolgen.

Um den inneren Konturen eines Kameramodulgehäuses zu folgen, weist das Abdeckelement 11 an zwei Ecken, an welchen die Bohrungen 18 ausgebildet sind, jeweils eine Aussparung auf.

Figur 4 zeigt ein Abdeckelement 11 gemäß Figur 3 in einer perspektivischen Unteransicht. Um das Funktionselement 50 gegenüber dem Fixierrahmen 48 und dem Kameramodulgehäuse (in Fig. 4 nicht dargestellt) leicht und zielsicher zu positionieren, weist das Funktionselement 50 an 2 Ecken jeweils eine Öse 19 auf.

In Figur 4 ist der Außenleiter 38 und der Innenleiter 36 der Fakra-Schnittstelle 16 zu erkennen. Der Außenleiter weist vier Schlitze auf, um ausreichend Elastizität für eine Steckverbindung auf einer Leiterplatte zu gewährleisten. Der Außenleiter 38 weist einen Rastring 39 auf, welcher geeignet ist, mit einem Verbinder einer Leiterplatte (nicht dargestellt) zu verrasten.

Figur 4 zeigt zudem das Kontaktelement 30 des EMV-Moduls 28. Das Kontaktelement 30 weist mehrere federnde Kontaktstreifen 31 auf, welche die Wandung 32 des EMV Moduls 28 in montierten Zustand kontaktieren. Die Kontaktstreifen 31 und die Wandung 32 sind derart ausgelegt, dass diese in montierten Zustand einander entgegenfedern. Dies wird erreicht, indem die Kontaktstreifen 31 aus einem dünnen bzw. leicht verformbaren leitenden Material gefertigt sind.

Um die Montage zu erleichtern weist das Funktionselement 50 des Abdeckelements 11 an zwei Ecken zwei Zentrierhilfen 40 auf. Die Zentrierhilfen 40 verhindern zudem, dass das Kontaktelement 30 verdreht bzw. verkehrt herum in das Abdeckelement eingesetzt wird. Diesbezüglich ist es insbesondere vorteilhaft, wenn sich die Zentrierhilfen 40 voneinander unterscheiden.

In Figur 4 ist dargestellt, dass das Kontaktelement 30 den Außenleiter 38 der Schnittstelle kontaktiert.

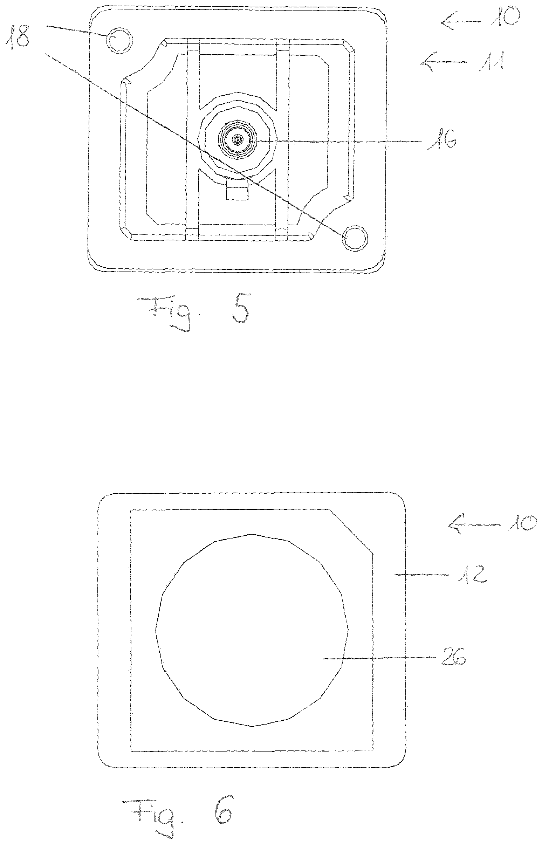

Figur 5 zeigt eine schematische Draufsicht eines erfindungsgemäßen Kameramoduls 10 gemäß der ersten Ausführungsform in Figur 1.

Figur 6 zeigt eine schematische Unteransicht eines erfindungsgemäßen Kameramoduls 10 gemäß der ersten Ausführungsform in Figur 1. Neben dem Kameramodulgehäuse 10 mit der umlaufenden Wandung 12 ist in Figur 6 zudem die Linse 26 dargestellt.

Obwohl die vorliegende Erfindung, die durch die folgenden Patentansprüche definiert ist, anhand bevorzugter Ausführungsbeispiele vorstehend vollständig beschrieben wurde, ist sie darauf nicht beschränkt, sondern auf vielfältige Art und Weise modifizierbar.

### Bezugszeichenliste

- 10: Kameramodul
- 10a: Kameramodul
- 10b: Kameramodul
- 10c: Kameramodul
- 11: Abdeckelement
- 12: Kameramodulgehäuse
- 12b: Kameramodulgehäuse
- 14: umlaufende Wandung
- 16: Schnittstelle
- 17: Schnittstellenummantelung
- 18: Befestigungspunkt
- 20: Leiterplattenanordnung
- 21: Leiterplatte
- 22: Leiterplatte
- 23: Leiterplatte
- 24: Ausgleichselement
- 25: Stufe
- 26: Linse
- 28: EMV-Modul
- 30: Kontaktelement
- 32: Wandung
- 33: Kontakt
- 35: Ausgleichselement
- 36: Innenleiter
- 38: Außenleiter
- 40: Zentrierelement
- 42: Ausnehmung
- 46: Steg
- 48: Fixierrahmen
- 50: Funktionselement
- 52: Vertiefung

## Patentansprüche

1. Kameramodul (10), insbesondere zur Verwendung im Automobilbereich, mit
- einer Leiterplattenanordnung (20; 21, 22, 23), wobei die Leiterplattenanordnung zumindest eine Leiterplatte (21) mit einem Bildsensor aufweist;
- einer Schnittstelle (16) zur Datenübertragung, welche die zumindest eine Leiterplatte (21) kontaktiert;
- einem Kameramodulgehäuse (12), welches eine umlaufende Wandung (14) aufweist;
- einem schnittstellenseitigem Abdeckelement (11), welches eingerichtet ist, das Kameramodulgehäuse abzudecken und in das Kameramodulgehäuse eingesetzt ist;
- einem Ausgleichselement (24), welches zwischen der umlaufenden Wandung und dem Abdeckelement angeordnet ist und welches eingerichtet ist, Fertigungstoleranzen auszugleichen;
wobei das Ausgleichselement eingerichtet ist, das Kameramodulgehäuse abzudichten sowie einen Spielraum zwischen dem Abdeckelement und der umlaufenden Wandung auszugleichen, **dadurch gekennzeichnet, dass** das Ausgleichselement einen H-oder hantelförmigen Querschnitt aufweist und als dreidimensionale Lippendichtung ausgebildet ist.

2. Kameramodul nach Anspruch 2, wobei die radiale Verformbarkeit des Ausgleichselements zwischen 0,001 % und 2 %, insbesondere zwischen 0,005 % und 1%, weiter insbesondere zwischen 0,1 % und 0,5 % des Durchmessers des Ausgleichselements beträgt.

3. Kameramodul nach einem der vorstehenden Ansprüche, wobei das Ausgleichselement als Mehrlippendichtung ausgebildet ist.

4. Kameramodul nach einem der vorstehenden Ansprüche, wobei das Ausgleichselement einen Härtegrad, welcher geringer ist als der Härtegrad eines O-Rings von vergleichbarem Durchmesser und einen Härtegrad zwischen 30 Shore und 50 Shore aufweist.

5. Kameramodul nach einem der vorstehenden Ansprüche, wobei das Abdeckelement mittels zweier Befestigungspunkte (18) an dem Kameramodulgehäuse fixiert ist.

6. Kameramodul nach einem der vorstehenden Ansprüche, wobei das Kameramodulgehäuse und/oder das Abdeckelement aus Kunststoff, insbesondere aus spritzgegossenem Kunststoff, gefertigt sind.

7. Kameramodul nach Anspruch 6, wobei das Abdeckelement aus Kunststoff und das Kameramodulgehäuse aus Metall, insbesondere Aluminium, gefertigt ist.

8. Kameramodul nach einem der vorstehenden Ansprüche, wobei die Abmessungen eines Querschnittes des Kameramoduls in der Deckelebene bis zu 50mm x 50mm, insbesondere bis zu 30mm x 30mm, betragen.

9. Kameramodul nach einem der vorstehenden Ansprüche, wobei zwischen der Leiterplattenanordnung und dem Kameramodulgehäuse ein EMV-Modul (28) angeordnet ist.

10. Kameramodul nach einem der vorstehenden Ansprüche, wobei das Ausgleichselement an dem Abdeckelement befestigt, insbesondere verklebt, ist.

11. Kameramodul nach einem der vorstehenden Ansprüche, wobei das Kameramodulgehäuse in einem Bereich des Ausgleichselements eine Vertiefung (52) aufweist.

12. Kraftfahrzeug mit einem Kameramodul (10) nach einem der vorstehenden Ansprüche.

## Claims

1. A camera module (10), in particular, for use in the automobile industry, having
- a printed circuit board assembly (20; 21, 22, 23), wherein the printed circuit board assembly has at least one printed circuit board (21) with an image sensor;
- an interface (16) for transmitting data, which contacts the printed circuit board (21);
- a camera module housing (12), which has a peripheral wall (14);
- a cover element (11) on the interface side, which is configured to cover the camera module housing and is inserted into the camera module housing;
- a compensation element (24), which is arranged between the peripheral wall and the cover element and which is configured to compensate for manufacturing tolerances;
wherein the compensation element is configured to seal the cameral module housing and to compensate for a clearance between the cover element and the peripheral wall, **characterized in that** the compensation element has an H- or dumbbell-shaped cross section and is designed as a three-dimensional lip seal.

2. The camera module according to claim 2, wherein the radial deformability of the compensation element is between 0.001% and 2%, in particular between 0.005% and 1%, further in particular between 0.1% and 0.5% of the diameter of the compensation element.

3. The camera module according to any one of the preceding claims, wherein the compensation element is designed as a multi-lip seal.

4. The camera module according to any one of the preceding claims, wherein the compensation element has a degree of hardness, which is less than the degree of hardness of an O-ring of comparable diameter and a degree of hardness between 30 Shore and 50 Shore.

5. The camera module according to any one of the preceding claims, wherein the cover element is fixed to the camera module housing by means of two fastening points (18).

6. The camera module according to any one of the preceding claims, wherein the camera module housing and/or the cover element are made from plastic, in particular from injection-molded plastic.

7. The camera module according to claim 6, wherein the cover element is made from plastic and the camera module housing from metal, in particular, aluminum.

8. The camera module according to any one of the preceding claims, wherein the dimensions of a cross section of the camera module in the lid plane are up to 50 mm x 50 mm, in particular, up to 30 mm x 30 mm.

9. The camera module according to any one of the preceding claims, wherein an EMC module (28) is arranged between the printed circuit board assembly and the camera module housing.

10. The camera module according to any one of the preceding claims, wherein the compensation element is fastened, in particular, adhesively bonded to the cover element.

11. The camera module according to any one of the preceding claims, wherein the camera module housing has a recess (52) in a region of the compensation element.

12. An automobile having a camera module (10) according to any one of the preceding claims.

## Revendications

1. Module de caméra (10), plus particulièrement destiné à être utilisé dans le secteur automobile, avec
- une disposition de circuit imprimé (20 ; 21 ; 22, 23), dans lequel la dispositif de circuit imprimé comprend au moins un circuit imprimé (21) avec un capteur d'image ;
- une interface (16) pour la transmission de données, qui est contact avec l'au moins un circuit imprimé (21) ;
- un boîtier de module de caméra (12) qui comprend une paroi périphérique (14);
- un élément de recouvrement côté interface (11), qui est conçu pour recouvrir le boîtier du module de caméra et pour être inséré dans le boîtier du module de caméra ;
- un élément de compensation (24), qui est disposé entre la paroi périphérique et l'élément de recouvrement et qui est conçu pour compenser les tolérances de fabrication ;
dans lequel l'élément de compensation est conçu pour étanchéifier le boîtier du module de caméra ainsi que pour compenser un jeu entre l'élément de recouvrement et la paroi périphérique, **caractérisé en ce que** l'élément de compensation présente une section transversale en forme de H ou en forme d'haltère et est conçu comme un joint d'étanchéité à lèvre tridimensionnel.

2. Module de caméra selon la revendication 2, dans lequel la déformabilité radiale de l'élément de compensation représente entre 0,001 % et 2 %, plus particulièrement entre 0,005 % et 1 %, plus particulièrement entre 0,1 % et 0,5 % du diamètre de l'élément de compensation.

3. Module de caméra selon l'une des revendications précédentes, dans lequel l'élément de compensation est conçu comme un joint d'étanchéité à plusieurs lèvres.

4. Module de caméra selon l'une des revendications précédentes, dans lequel l'élément de compensation présente un degré de dureté inférieure au degré de dureté d'un joint torique d'un diamètre comparable et un degré de dureté entre 30 Shore et 50 Shore.

5. Module de caméra selon l'une des revendications précédentes, dans lequel l'élément de recouvrement est fixé au moyen de deux points de fixation (18) au boîtier du module de caméra.

6. Module de caméra selon l'une des revendications précédentes, dans lequel le boîtier du module de caméra et/ou l'élément de recouvrement sont constitués d'une matière plastique, plus particulièrement d'une matière plastique moulée par injection.

7. Module de caméra selon la revendication 6, dans lequel l'élément de recouvrement est constitué d'une matière plastique et le boîtier du module de caméra est constitué de métal, plus particulièrement d'aluminium.

8. Module de caméra selon l'une des revendications précédentes, dans lequel les dimensions d'une section transversale du module de caméra représentent, dans le plan du couvercle, jusqu'à 50 mm x 50 mm, plus particulièrement jusqu'à 30 mm x 30 mm.

9. Module de caméra selon l'une des revendications précédentes, dans lequel, entre la disposition de circuit imprimé et le boîtier du module de caméra, est disposé u module CEM (28).

10. Module de caméra selon l'une des revendications précédentes, dans lequel l'élément de compensation est fixé, plus particulièrement collé, à l'élément de recouvrement.

11. Module de caméra selon l'une des revendications précédentes, dans lequel le boîtier du module de caméra comprend une cavité (52) dans une partie de l'élément de compensation.

12. Véhicule automobile avec un module de caméra (10) selon l'une des revendications précédentes.
